# EUROPEAN PATENT APPLICATION

(11) **EP 1 659 822 A1**
(43) Date of publication of application: **24.05.2006**
(21) Application number: 05755886.8
(22) Date of filing: 30.06.2005
(51) Int. Cl.: H04R 1/10, H05K 1/02

(54) **EARPHONE ANTENNA CONNECTING DEVICE AND PORTABLE WIRELESS DEVICE**

(30) Priority: 08.07.2004 JP 2004202322
(71) Applicant: SONY CORPORATION, Tokyo 141-0001 (JP)
(72) Inventor: YOSHINO, Yoshitaka, c/o SONY CORPORATION, Shinagawa-ku, Tokyo 1410001 (JP)
(74) Representative: Mills, Julia
(86) International application number: PCT/JP2005/012072
(87) International publication number: WO 2006/006416

(57) **Abstract**

In a liquid crystal TV receiver, when the pins (11 to 20) of the 10-pin connector plug (115) are soldered to the pins of the pin-plug connector (110) used for connection of the coaxial cable (60) used to transmit low-frequency and RF signals to a body (120) of the TV receiver, the conversion board is provided between the pins of the 10-pin connector plug (115) and pins of the pin-plug connector (110) and the rear-side pattern of the conversion board except for the pin insertion hole (10) in which the pin (20) to which the antenna signal line (9) is to be connected is to be inserted is formed as the grounding pattern to surround at least three sides of the pin insertion holes (134A, 135A and 132A) in which the audio signal pins (14 and 15) through which low-frequency signals such as audio signals are passed and the microphone pin (12) are to be inserted, respectively. Thus, the RF characteristic and suppression of audio noises are considerably improved.

## Description

Earphone Antenna Connecting Device and Portable Radio Set

### Technical Field

The present invention relates to an earphone antenna connecting device through which RF and low-frequency signals are transmitted together, and to a portable radio set.

This application claims the priority of the Japanese Patent Application No. 2004-202322 filed in the Japanese Patent Office on July 8, 2004, the entirety of which is incorporated by reference herein.

### Background Art

As disclosed in, for example, the Japanese Patent Application Laid Open No. 2003-163529, each of portable radio sets such as a wearable pager, radio receiver, liquid crystal TV receiver, etc. have used in the past a rod antenna or an earphone antenna using audio signal transmission lines to the earphone as an antenna.

Also, in case an antenna with a coaxial line is connected to the above-mentioned portable radio set, the latter uses a dedicated connector for the antenna and a ferrite bead is inserted under a headphone terminal to filter out a noise carried on audio signals to a headphone, as disclosed in the Japanese Patent Application Laid Open No. 199237 of 1997.

However, the portable radio set with an earphone antenna which transmits RF and low-frequency signal (audio signal) together has a problem of how to suppress noises at a connector at which the earphone antenna is connected to the portable radio set.

More specifically, though the RF signal is normally transmitted through a coaxial line, each of transmission lines in the coaxial cable is formed from a contact element in the connector. So, shielding the transmission lines individually will lead to an increased size of the connector and thus a noise suppression by insertion of beads or the like is required, which limits the freedom of designing a radio set.

### Disclosure of the Invention

It is therefore desirable to overcome the above-mentioned drawbacks of the related art by suppressing noises from audio and microphone signals to the radio set and improving the characteristic of high-frequency signal transmission through the connector and also the freedom of circuit board layout.

The present invention is directed to considerably improving the characteristic of a connector using pins for connection with a cable by connecting the connector pins with the cable via a single circuit board in case RF and low-frequency signals are to be transmitted together through the connector and devising the pattern of the circuit board.

According to the present invention, there is provided an earphone antenna connecting device for connecting an earphone antenna including high- and low-frequency signal transmission lines to the body of a portable radio set via a pin-plug connector, the device including, according to the present invention, a conversion board formed from a double-sided printed circuit board having formed therein pin insertion holes in which pins of the pin-plug connector are to be inserted, the conversion board having formed on one side thereof a connecting pattern having connecting lands formed around the pin insertion holes, respectively, and connecting lands to which the transmission lines are to be connected, and on the other side a grounding pattern not including a portion of the conversion board where there are formed the pin insertion holes for the pins to which the antenna signal lines are to be connected, and which is formed to surround at least three sides of each of the pin insertion holes in which signal pins through which the low-frequency signal is to pass are to be inserted.

The above earphone antenna connecting device according to the present invention connects, to the portable radio set body via the pin-plug connector, the earphone antenna which is a sleeve antenna formed from a coaxial wire as high- and low-frequency signal transmission lines formed from an audio signal wire and antenna signal wire, which are core conductors, and an antenna/sound grounding wire as a shielding wire, and an earphone cable connected to one end of the coaxial wire via a means for separating the high- and low-frequency signals from each other, the pin-plug connector being connected to the other end of the coaxial wire.

According to the present invention, there is also provided a portable radio set to which an earphone antenna including a high- and low-frequency signal transmission lines to a portable radio set via an earphone antenna connecting device using a pin-plug connector, the earphone antenna connecting device including, according to the present invention, a conversion board formed from a double-sided printed circuit board having formed therein pin insertion holes in which pins of the pin-plug connector are to be inserted, the conversion board having formed on one side thereof a connecting pattern having connecting lands formed around the pin insertion holes, respectively, and connecting lands to which the transmission lines are to be connected, and on the other side a grounding pattern not including a portion of the conversion board where there are formed the pin insertion holes for the pins to which the antenna signal lines are to be connected, and which is formed to surround at least three sides of each of the pin insertion holes in which signal pins through which the low-frequency signal is to pass are to be inserted.

In the above portable radio set according to the present invention, the earphone antenna is a sleeve antenna formed from a coaxial wire as a transmission line for the high- and low-frequency signals, formed from an audio and antenna signal wires as core conductors and an antenna/sound grounding wire as a shielding wire, and an earphone cable connected to one end of the coaxial wire via a means for separating the high- and low-frequency signals from each other, the earphone antenna connecting device having the pin-plug connector thereof connected to the other end of the coaxial wire.

According to the present invention, when the pins of the connector plug are soldered to the pins of the pin-plug connector used for connection of the cable used to transmit analog and high-frequency signals to the receiver body, the conversion board is provided between the pins of and pins of the pin-plug connector and the rear-side pattern of the conversion board except for the pin insertion hole in which the pin to which the antenna signal line is to be connected is to be inserted is formed as the grounding pattern to surround at least three sides of the pin insertion holes in which the signal pins through which low-frequency signals such as audio signals are passed are to be inserted, respectively. Thus, the RF characteristic and suppression of audio noises are considerably improved.

Therefore, according to the present invention, it is possible to suppress noises from audio signals and microphone signals to the portable radio set and improve the characteristic of high-frequency signal transmission of the connector and also the freedom of circuit board layout.

These objects and other objects, features and advantages of the present invention will become more apparent from the following detailed description of the best mode for carrying out the present invention when taken in conjunction with the accompanying drawings.

### Brief Description of the Drawings

FIG. 1 is a block diagram of a liquid crystal TV receiver according to the present invention.
FIG. 2 is also a block diagram of a receiver body of the liquid crystal TV receiver in FIG 1.
FIG. 3 illustrates the configuration of the coaxial cable included in the earphone antenna.
FIG. 4 illustrates the configuration of an interconnecting block included in the earphone antenna.
FIG. 5 is an electrical circuit diagram of the earphone antenna.
FIGS. 6A to 6E show the configuration of a 10-pin connector plug used as a 10-pin connector plug included in a pin-plug connector that connects the liquid crystal TV receiver and earphone antenna to each other.
FIGS. 7A and 7B show the configuration of a conversion board which is combined with the 10-pin connector plug.
FIGS. 8A to 8D show the configuration of a molded plug connector.

### Best Mode for Carrying Out the Invention

The present invention will be described in detail below concerning an embodiment thereof with reference to the accompanying drawings. It should be understood by those ordinarily skilled in the art that the present invention is not limited to the embodiment that will be illustrated and described below but can of course be modified in various manners, constructed alternatively or embodied in various other forms without departing from the scope and spirit thereof as set forth and defined in the appended claims.

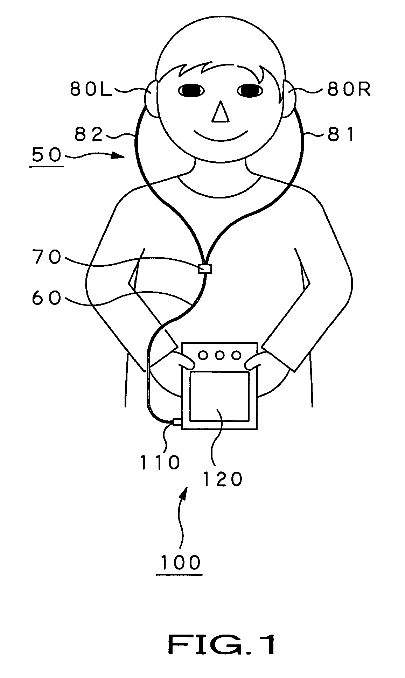

The present invention is applicable to a liquid crystal TV receiver 100 constructed as shown by way of example in FIG. 1.

The liquid crystal TV receiver 100 shown in FIG. 1 is provided with an earphone antenna 50 which is connected to a receiver body 120 via a pin-plug connector 110. TV signals received by the earphone antenna 50 are sent to the receiver body 120 and audio signals from the receiver body 120 are sent to stereo earphones 80L and 80R via the earphone antenna 50.

The earphone antenna 50 includes a coaxial cable 60 connected at one end thereof to the receiver body 120 via the pin-plug connector 110, interconnecting block 70 connected to the other end of the coaxial cable 60, and stereo earphones 80L and 80R connected to the interconnecting block 70 via two earphone cables 81 and 82, respectively.

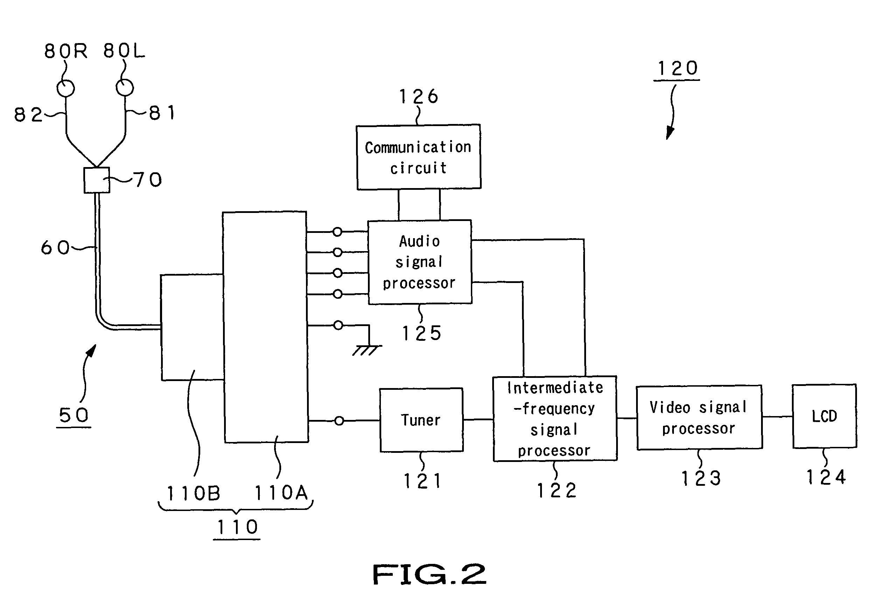

As shown in FIG 2, the receiver body 120 includes a tuner 121, intermediate-frequency signal processor 122 connected to the tuner 121, video signal processor 123 and audio signal processor 125 connected to the intermediate-frequency signal processor 122, liquid crystal display 124 connected to the video signal processor 123, communication circuit 126, and a connector 110A included in the pin-plug connector 110.

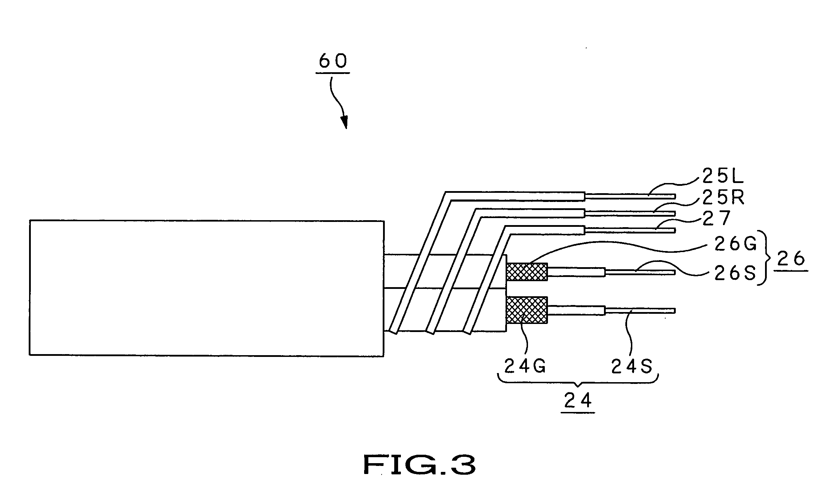

As shown in FIG. 3, the coaxial cable 60 includes an antenna coaxial line 24 (antenna signal line 24S and antenna/audio grounding line 24G) connected to the tuner 121, and an audio signal line (right) 25R, audio signal line (left) 25L, microphone coaxial line 26 (microphone signal line 26S and microphone grounding line 26G) and switch line 27, all connected to the audio signal processor 125. The audio signal lines 25L and 25R are grounded to a point to which the antenna coaxial line 24 is also grounded. The insulation-coated audio signal lines 25L and 25R and switch line 27 are wound on the antenna coaxial line 24 and microphone coaxial line 26. The coaxial cable 60 has a pin plug 110B included in the pin-plug connector 110 connected to one end thereof and the interconnecting block 70 connected to the other end.

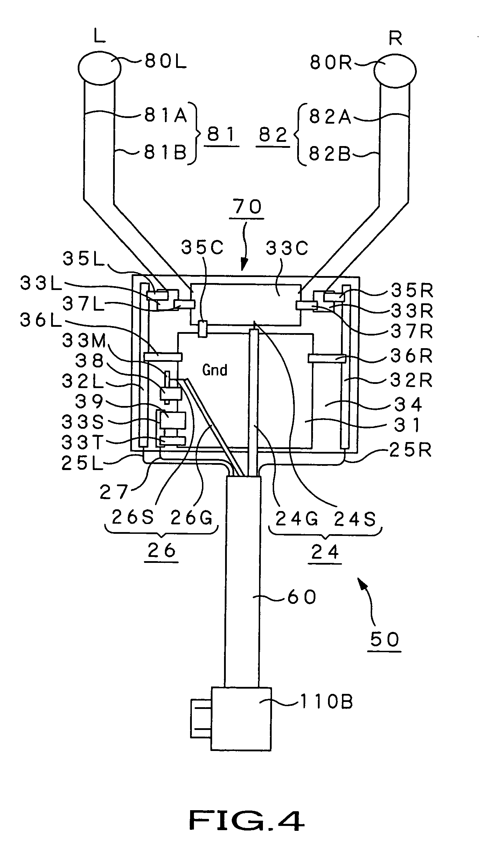

As shown in FIG. 4, the interconnecting block 70 includes a circuit board 34 having a grounding pattern 31 formed at the center thereof, stereo audio signal transmission patterns 32L and 32R formed across the grounding pattern 31, three connecting lands 33L, 33R and 33C formed at the end of the grounding pattern 31, microphone connecting pattern 33M and a switch connecting pattern 33S. As seen, the circuit board 34 has mounted thereon high-frequency chokes 35L and 35R connecting the ends of the stereo audio signal transmission line patterns 32L and 32R to the first and second ones (33L and 33R), respectively, of the three connecting lands 33L, 33R and 33C, high frequency choke 35C connecting the grounding pattern 31 to the third one (33C) of the three connecting lands 33L, 33R and 33C, chip capacitors 36L and 36R connecting the stereo audio signal transmission line patterns 32L and 32R to the grounding patter 31, chip capacitor 37L connecting the first connecting land 33L to the third connecting land 33C and a chip capacitor 37R connecting the second connecting land 33R to the third connecting land 33C. Also, the circuit board 34 has a microphone 38 mounted between the grounding pattern 31 and microphone connecting pattern 33M and a switch 39 mounted between the switch connecting pattern 33S and grounding pattern 31. Further, the circuit board 34 has a chip capacitor 33T mounted between the switch connecting pattern 33S and grounding pattern 31.

Also in the interconnecting block 70, a left earphone cable 81 including two signal lines 81A and 81B to supply left audio signals to the left earphone 80L is connected to the first and third connecting lands 33L and 33C, and a right earphone cable 82 including two signal lines 82A and 82B to supply right audio signals to the right earphone 80R is connected to the second and third connecting lands 33R and 33C.

Further the interconnecting block 70 has the coaxial cable 60 connected thereto as will be described below.

The audio signal transmission line patterns 32L and 32R formed on the circuit board 34 have connected thereto the left and right audio signal lines 25L and 25R, respectively, of the coaxial cable 60, the microphone signal line 26S of the microphone coaxial line 26 is connected to the microphone connecting pattern 33M, and the microphone grounding line 26G is connected to the grounding pattern 31. Further, the grounding pattern 31 has mounted thereon the core conductor and shielding line of the coaxial cable 60, that is, the antenna line 24S and antenna/audio grounding line 24G, the antenna/audio grounding line 24G is connected to the grounding pattern 31 and the antenna signal line 24S is connected at the end thereof to the third connecting land 33C.

In this embodiment, the high-frequency chokes 35L, 35R and 35C use ferrite beads (for example, BLM18HD102SN1, 1608 in size, by Murata Seisakusho). Each of the high-frequency chokes 35L, 35R and 35C using the ferrite beads is a low impedance to an audio signal included in the frequency domain of less than 20 kHz, and a high impedance to a high-frequency signal which will thus be blocked from passing by. Also, each of the chip capacitors 36L, 36R, 37L, 37R and 33T has a capacity of 1000 pF. It is a high impedance to an audio signal included in the frequency domain of less than 20 kHz to block the audio signal from passing by, and a low impedance to a high-frequency signal.

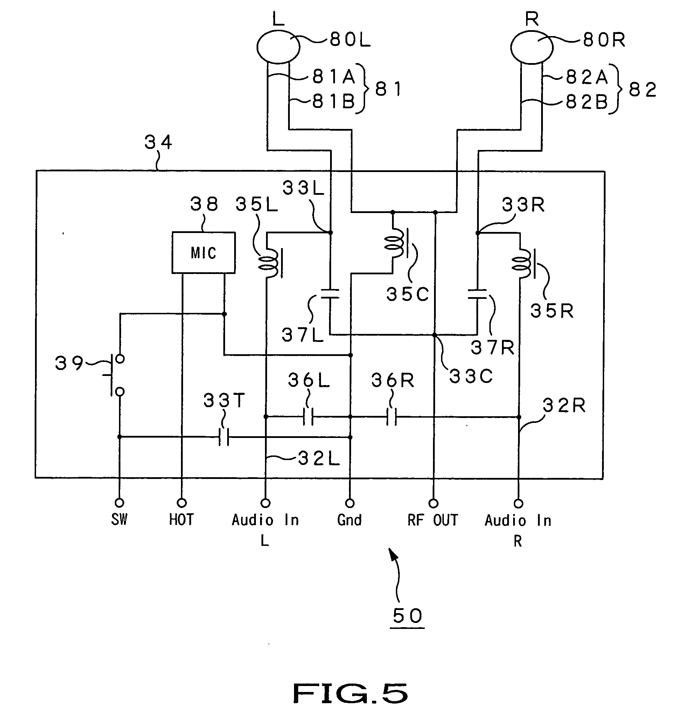

As will be seen in the electrical circuit diagram in FIG. 5, in the earphone antenna 50, the earphone cable 81 including the two signal lines 81A and 81B and GND (grounding) line and earphone cable 82 include the two signal lines 82A and 82B and GND line are led out from the earphone antenna 50 to transmit audio signals to speakers in the stereo earphones 80L and 80R, and the high-frequency chokes 35L, 35R and 35C using the ferrite beads are provided in the audio signal input and portion connected to the ground potential, that is, the connecting lands 33L, 33R and 33C, to separate audio and high-frequency signals from each other. The high-frequency chokes 35L, 35R and 35C provide a high impedance (1 kΩ or more) to a frequency included in the frequency band used for the TV broadcast and also a low impedance to a frequency included in the audio frequency band (20 kHz or less) to separate the audio and high-frequency signals from each other.

Also, the earphone cables 81 and 82 each including two signal lines are connected to the core conductor of the coaxial cable 60 the antenna signal line 24, that is, the antenna signal line 24S, for the high-frequency signals. For assuring the separation of the high-frequency signals from audio signals, the chip capacitor 37L of 1000 pF is connected between the first and third connecting lands 35L and 33C while the chip capacitor 37R of 1000 pF is connected between the second and third connecting lands 33R and 33C. Thus, for the audio signals, the two signal lines 81A and 81B included in the earphone cable 81 and two signal lines 82A and 82B included in the earphone cable 82 are separated from the antenna signal line 24S. For the high-frequency signals (in the frequency band for the TV broadcast), the two signal lines 81A and 81B included in the earphone cable 81 form together one antenna line while the two signal lines 82A and 82B included in the earphone cable 82 form together another antenna line.

Note here that the frequency band used for the TV broadcast in Japan ranges from 90 to 108 MHz (channels 1 to 3) and 170 to 222 MHz (channels 4 to 12) in the VHF band and also from 470 to 770 MHz (channels 13 to 62) in the UHF band.

On this account, the antenna/audio grounding line 24G having the coaxial structure is connected directly to the grounding pattern 31 to form the earphone antenna 50 having the sleeve antenna structure of which a range down to earphone cables 81 and 82 connected to the antenna/audio grounding line 24G and antenna signal line 24S in the antenna coaxial line 24 resonates, and each of the earphone cables is set in length to receive a frequency of 100 MHz in the VHF band.

In the earphone antenna 50 according to this embodiment, the coaxial cable 60 has a coaxial structure of 75 Ω in characteristic impedance and of 700 mm in length and the earphone cables 81 and 82 are 40 cm in length to resonate at a frequency of 100 MHz. The earphone antenna 50 is also designed to have a 1λ antenna structure for reception of 200 MHz and uses a harmonic excitation of 100 MHz and 200 MHz (threefold wave, fivefold wave and sevenfold wave) in the UHF band.

Each of the audio signal lines in the coaxial cable 60 is connected to the grounding pattern 31 via the capacitors 36L and 36R of 10 pF in the interconnecting block 70, and to the shielding line 23 in the coaxial cable 60. Thus, the signal lines function as grounding line in the high-frequency domain.

Because of the sleeve structure, the earphone antenna 50 according to this embodiment works stably as an antenna. Also, the interconnecting block 70 may have various functions added thereto. In this embodiment, the function of the microphone 38 is added to the interconnecting block 70 for the mobile phone, for example.

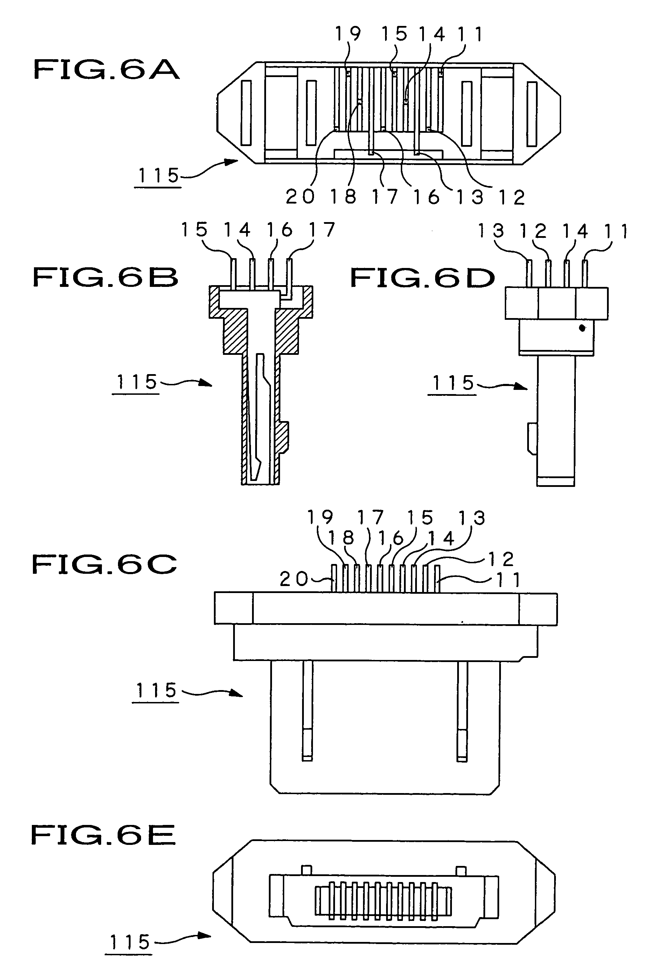

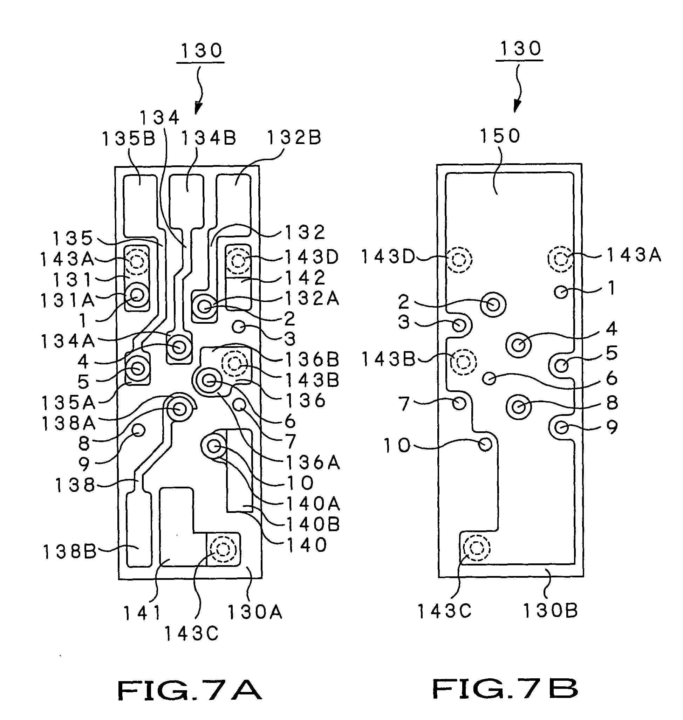

In the liquid crystal TV receiver 100, the pin plug 110B included in the pin-plug connector 110 includes a 10-pin connector plug 115 designed as shown in FIGS. 6A, 6B, 6C, 6D and 6E and a conversion board 130 designed as shown in FIG. 7, and each of the lines in the coaxial cable 60 included in the earphone antenna 50 is connected at one end thereof to the 10-pin connector plug 115 via the conversion board 130.

The conversion board 130 has ten pin insertion holes 1 to 10 formed therein. As shown in FIG. 7A, the conversion board 130 has formed one main side 130A thereof a grounding pattern 131 having a connecting land 131A formed around the pin insertion hole 1 in which a grounding pin 11 is to be inserted, a microphone connecting pattern 132 having a connecting land 132A formed around the pin insertion hole 2 in which a microphone pin 12 is to be inserted and a microphone connecting land 132B, an audio signal (right) connecting pattern 134 having a connecting land 134A formed around the pin insertion hole 4 in which an audio signal (right) pin 14 is to be inserted and an audio signal (right) connecting land 134B, an audio signal (left) connecting pattern 135 having a connecting land 135A formed around the pin insertion hole 5 in which an audio signal (left) pin 15 is to be inserted and an audio signal (left) connecting land 135B, a stereo/monaural detection connecting pattern 136 having a connecting land 136A formed around the pin insertion hole 6 in which a stereo/monaural detection pin 16 is to be inserted and a stereo/monaural detection connecting land 136B, a switch connecting pattern 138 having a connecting land 138A formed around the pin insertion hole 8 in which a switch pin 18 is to be inserted and a switch connecting land 138B, an antenna connecting pattern 140 having a connecting land 140A formed around the pin insertion hole 10 in which an antenna pin 20 is to be inserted and an antenna connecting land 140B, and an antenna/audio grounding land 141.

Note here that the grounding pattern 131, stereo/monaural detection connecting pattern 136 and antenna/audio grounding land 141 formed on the one main side 130A of the conversion board 130 are connected to a grounding pattern 150 formed on the other main side 130B of the conversion board 130 via through-holes 143A, 143B and 143C, respectively.

As shown in FIG. 7B, the other main side 130B of the conversion board 130, except for a portion around the pin insertion hole 10 in which the antenna pin 20 is to be inserted, is formed as the grounding pattern 150 to surround at least three sides of the pin insertion holes 134A, 135A and 132A in which the audio signal pins 14 and 15 connected to the audio signal lines and the microphone pin 12 connected to the microphone signal line 26S are to be inserted, respectively, in order to suppress noises in the low-frequency domain and improve the high-frequency characteristic. The mean noise suppression by 1 to 2 dB was attained in the high-frequency domain (UFH band). Also, since the other main side of the conversion board 130 is formed as the grounding pattern, the microphone coaxial line 26 can be grounded to a nearby place by providing, near the microphone grounding connecting land 132B connecting the microphone signal line 26S on the one main side of the conversion board 130, a microphone grounding connecting land 142 connected to the grounding pattern 150 through the through-hole 143D. Also, by connecting the stereo/monaural detection pin 16 to the stereo/monaural detection connecting land 136B to set a short-circuit mode, stereo detection can be done more easily and the layout of the conversion board can be designed with an improved freedom.

In the conversion board 130, pins 11 to 20 at the 10-pin connector plug 115 are inserted in the pin insertion holes 1 to 10 and the pins 11 to 20 are fixed by soldering to the connecting lands 131A to 140A on the conversion board 130. In addition, the signal lines of the earphone antenna 50 are sequentially soldered, starting with the antenna signal line 9, to the connecting lands.

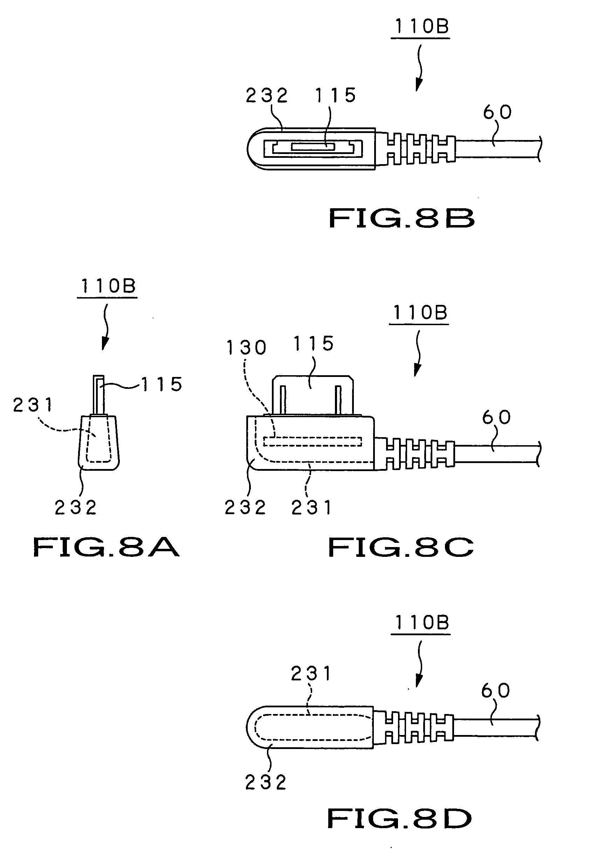

Further, in the pin plug 110B of the liquid crystal TV receiver100, each line in the coaxial cable 60 included in the earphone antenna 50 is connected at one end thereof to the 10-pin connector plug 115 via the conversion board 130, then polypropylene (PP) is applied to the connected lines to form an inner mold 231, and a polyester resin is applied to the inner mold 231 to form an outer mold 232. Thus, the 10-pin connector plug 115 and lines of the coaxial cable 60 are integrated together as shown in FIGS. 8A, 8B, 8C and 8D. It should be noted that the antenna pin 20 is provided at the peripheral portion, not inside the pins.

In the liquid crystal TV receiver 100, when the pins 11 to 20 of the 10-pin connector plug 115 are soldered to the pins of the pin-plug connector 110 used for connection of the coaxial cable 60 used to transmit low-frequency and RF signals to the receiver body 120, the conversion board is provided between the pins 11 to 20 and pins of the pin-plug connector 110 and the rear-side pattern of the conversion board except for the pin insertion hole 10 in which the pin 20 to which the antenna signal line 9 is to be connected is to be inserted is formed as the grounding pattern to surround at least three sides of the pin insertion holes 134A, 135A and 132A in which the audio signal pins 14 and 15 through which low-frequency signals such as audio signals are passed and the microphone pin 12 are to be inserted, respectively. Thus, the RF characteristic and suppression of audio noises are considerably improved.

## Claims

1. An earphone antenna connecting device for connecting an earphone antenna including high- and low-frequency signal transmission lines to a portable radio set via a pin-plug connector, the device comprising:
a conversion board formed from a double-sided printed circuit board having formed therein pin insertion holes in which pins of the pin-plug connector are to be inserted,
the conversion board having formed on one side thereof a connecting pattern having connecting lands formed around the pin insertion holes, respectively, and connecting lands to which the transmission lines are to be connected, and on the other side a grounding pattern not including a portion of the conversion board where there are formed the pin insertion holes for the pins to which the antenna signal lines are to be connected, and which is formed to surround at least three sides of each of the pin insertion holes in which signal pins through which the low-frequency signal is to pass are to be inserted.

2. The device according to claim 1, wherein there is connected to the portable radio set body via the pin-plug connector the earphone antenna which is a sleeve antenna formed from a coaxial wire as high- and low-frequency signal transmission lines formed from an audio signal wire and antenna signal wire, which are core conductors, and an antenna/sound grounding wire as a shielding wire, and an earphone cable connected to one end of the coaxial wire via a means for separating the high- and low-frequency signals from each other,
the pin-plug connector being connected to the other end of the coaxial wire.

3. A portable radio set to which an earphone antenna including a high- and low-frequency signal transmission lines to a portable radio set via an earphone antenna connecting device using a pin-plug connector, the earphone antenna connecting device comprising:
a conversion board formed from a double-sided printed circuit board having formed therein pin insertion holes in which pins of the pin-plug connector are to be inserted,
the conversion board having formed on one side thereof a connecting pattern having connecting lands formed around the pin insertion holes, respectively, and connecting lands to which the transmission lines are to be connected, and on the other side a grounding pattern not including a portion of the conversion board where there are formed the pin insertion holes for the pins to which the antenna signal lines are to be connected, and which is formed to surround at least three sides of each of the pin insertion holes in which signal pins through which the low-frequency signal is to pass are to be inserted.

4. The portable radio set according to claim 3, wherein the earphone antenna is a sleeve antenna formed from a coaxial wire as a transmission line for the high- and low-frequency signals, formed from an audio and antenna signal wires as core conductors and an antenna/sound grounding wire as a shielding wire, and an earphone cable connected to one end of the coaxial wire via a means for separating the high- and low-frequency signals from each other,
the earphone antenna connecting device has the pin-plug connector thereof connected to the other end of the coaxial wire.
